# EUROPÄISCHE PATENTSCHRIFT

(11) **EP 1 381 262 B1**
(45) Veröffentlichungstag und Bekanntmachung des Hinweises auf die Patenterteilung: **07.03.2007**
(21) Anmeldenummer: 03013904.2
(22) Anmeldetag: 20.06.2003
(51) Int. Cl.: H05K 5/00, B60R 16/02

(54) **Elektrisches Gerät, insbesondere Schalt- und/oder Steuergerät für Kraftfahrzeuge**
Electrical device, particularly for switching and/or controlling device in vehicle
Appareil électrique, appareil de commutation et/ou de contrôle d' automobile en particulier

(30) Priorität: 10.07.2002 EP 02014990
(43) Veröffentlichungstag der Anmeldung: 14.01.2004
(73) Patentinhaber: Tyco Electronics AMP GmbH, 64625 Bensheim (DE)
(72) Erfinder: Koperly, Ayad, 64625 Bensheim (DE); Spielvogel, Michael, 67098 Bad Türkheim (DE); Seipel, Volker, 64404 Bickenbach (DE); Hetschger, Thomas, 89173 Lonsee (DE)
(74) Vertreter: Patentanwaltskanzlei WILHELM & BECK

(56) Entgegenhaltungen:
- DE-A- 4 221 137
- DE-A- 19 515 622
- DE-C- 19 701 469
- US-A- 6 163 460

## Beschreibung

Die Erfindung betrifft ein elektrisches Gerät, insbesondere ein Schalt- und/oder Steuergerät für Kraftfahrzeuge, gemäß dem Oberbegriff des unabhängigen Anspruchs.

Derartige elektrische Geräte weisen typischerweise ein geschlossenes Gehäuse sowie einen Anschlussbereich auf, der als Steckbuchse ausgestaltet sein kann. Im Gehäuse ist meist eine Leiterplatte mit darauf befindlichen Schaltungskomponenten verschraubt oder anderweitig fixiert, deren Anschlusskontakte mit dem Steckbuchsenbereich elektrisch leitend verbunden sind. Dies kann beispielsweise über Kontaktstifte erfolgen, die ggf. eine Umlenkung um 90° aufweisen.

Ein gattungsgemäßes elektrisches Gerät, das insbesondere als Schalt- und/oder Steuergerät im Kraftfahrzeug eingesetzt werden kann, ist aus der DE 42 21 137 A1 bekannt. Dieses elektrische Gerät weist eine bestückte Leiterplatte mit einer Steckerleiste auf, die in einem aus einem Oberteil und einem Unterteil zusammengesetzten Gehäuse angeordnet ist. Die Steckerleiste mit Steckverbindungselementen ragt durch die Vorderwand des Gehäuses. Die Steckerleiste ist zweiteilig ausgeführt und besteht aus einem Steckerkörper und einer Grundplatte. Die Grundplatte wird von außen an die Vorderwand angesetzt, wobei Verriegelungselemente die Steckeröffnung durchdringen und an der Innenseite verrasten. Die Leiterplatte mit Steckerkörper wird von der Innenseite her eingesetzt, so dass der Steckerkörper das Gehäuse durchdringt und die Verrieglungselemente sichert und damit die Grundplatte auch bei hohen Kräften sicher fixiert.

Weitere Steuermodule von Kraftfahrzeugen sind beispielsweise aus der DE 195 15 622 A1 sowie aus der 197 01 469 C1 bekannt. Diese elektronischen Steuermodule weisen jeweils einen Trägerkörper auf, auf denen ein Schaltungsträger zur Aufnahme einer Schaltungsanordnung mit einer Vielzahl von zu kontaktierenden Schaltungselement planar aufgebracht ist. Das Steuermodul weist weiterhin einen Gehäusekörper auf, in dem ein Anschlusssteckerteil und eine Dichtung integriert sind. Trägerkörper und Gehäusekörper sind derart zusammenfügbar, dass ein abgedichtetes Außengehäuse gebildet wird.

Die US 5 280 410 offenbart ein elektrisches Schalt- und Steuergerät für Kraftfahrzeuge, das elektronische Leistungsbauelemente, die auf einer Leiterplatte angeordnet sind, in einem Gehäuse enthält und über einen Kühlkörper eine in ihnen erzeugte Wärme nach außen hin abführt.

Aufgabe der Erfindung ist es, ein elektrisches Gerät zur Verfügung zu stellen, das bei kompakten Abmessungen eine möglichst einfache Montage ermöglicht und dabei kostengünstig herstellbar ist.

Diese Aufgabe wird erfindungsgemäß durch den Gegenstand des unabhängigen Anspruchs gelöst. Merkmale vorteilhafter Weiterbildungen der Erfindung ergeben sich aus den abhängigen Ansprüchen.

Dem gemäß weist ein elektrisches Gerät, insbesondere ein Schalt- und/oder Steuergerät für Kraftfahrzeuge einen Gehäusekörper und einen Trägerkörper zur Aufnahme eines Schaltungsträgers auf, auf dem eine Schaltungsanordnung mit einer Vielzahl von zu kontaktierenden Schaltungskomponenten aufgebracht ist. Der Trägerkörper ist zum Einschub in einen Gehäusekörper unter Bildung eines abgedichteten Außengehäuses vorgesehen. An einer Frontseite des Trägerkörpers ist eine Fädelplatte und eine Stiftleiste angeordnet. Erfindungsgemäß sind die Fädelplatte und die mit dieser eine bauliche Einheit bildende Stiftleiste jeweils integrativer Bestandsteil des Trägerkörpers.

Mit dem erfindungsgemäßen elektrischen Geräts ist eine Minimierung der Anzahl von Bauteilen durch Kombination eines komplexen Leiterplatten- und Bauelementrahmens mit einer Fädelplatte sowie einer Integration von Verriegelungs- und Verbindungselementen ermöglicht. Gegenüber dem bisher bekannten Stand der Technik, der separate Rahmen, Stiftleiste und Fädelplatten vorsieht, können sehr kompakte Geräte realisiert werden, die zudem einfach herstellbar und schnell montierbar sind.

Eine Ausführungsform der Erfindung sieht vor, dass an der Frontseite des Trägerkörpers eine Dichtung vorgesehen ist zur Abdichtung des mit dem Schaltungsträger versehenen und in den Gehäusekörper eingeschobenen Trägerkörpers.

Vorzugsweise ist die Frontseite des Trägerkörpers mit einem Steckbuchsenkörper verbindbar, der bei in den Gehäusekörper eingeschobenem Trägerkörper von außen zugänglich ist. Anstatt eines Steckbuchsenkörpers kann eine beliebig andere verfügbare Verbindungsart gewählt werden, so dass das elektrische Gerät mit einer Schaltungsperipherie und/oder einem Kabelbaum oder dergleichen verbunden werden kann.

Der Trägerkörper weist vorzugsweise eine offene Rahmenstruktur mit einem stabilen umlaufenden Rahmensteg auf, wobei in der Rahmenstruktur weitere Verbindungsstege vorgesehen sein können. In der Rahmenstruktur können weiterhin Bauteilaufnahmen zur Abstützung von größeren Bauteilen, beispielsweise von Kondensatoren, Elektrolytkondensatoren, Spulen oder dergleichen, vorgesehen sein.

Der Schaltungsträger kann im Trägerkörper verrastbar sein, so dass eine Verschraubung oder anderweitige Fixierung nicht notwendig ist. Auch dadurch können weiterhin Bauteile eingespart werden. Zudem kann der Trägerkörper in vorteilhafterweise mit dem Gehäusekörper verrastbar sein, so dass auch hier keine weiteren Verbindungselemente oder -bauteile notwendig sind.

Im wesentlichen besteht das erfindungsgemäße elektrische Gerät aus nur zwei Bauteilen, wodurch ein äußerst geringer Montageaufwand bei geringen Montagekosten ermöglicht wird. Fädelplatte und Verriegelungselemente sind in die unverzichtbaren Bauteile, Stiftleiste und Trägerrahmen, integriert. Das erfindungsgemäße elektrische Gerät kann beispielsweise als Steuergerät einer Insassenschutzvorrichtung im Kraftfahrzeug Verwendung finden.

Der Erfindung wird nachfolgend anhand eines Ausführungsbeispiels unter Bezugnahme auf die Zeichnung näher erläutert. Dabei zeigen:

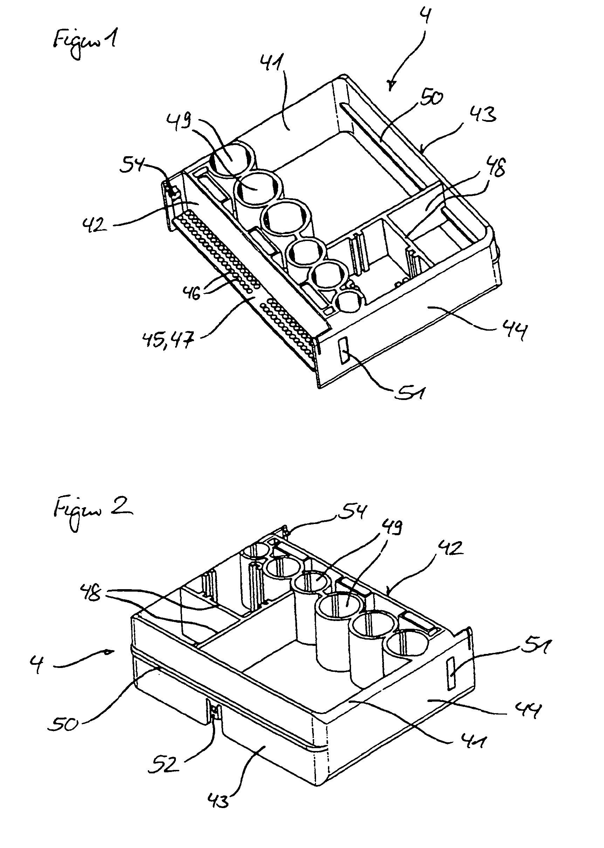

- Figuren 1 und 2: jeweils schematische Perspektivdarstellungen eines Trägerkörpers eines erfindungsgemäßen elektrischen Steuergeräts,

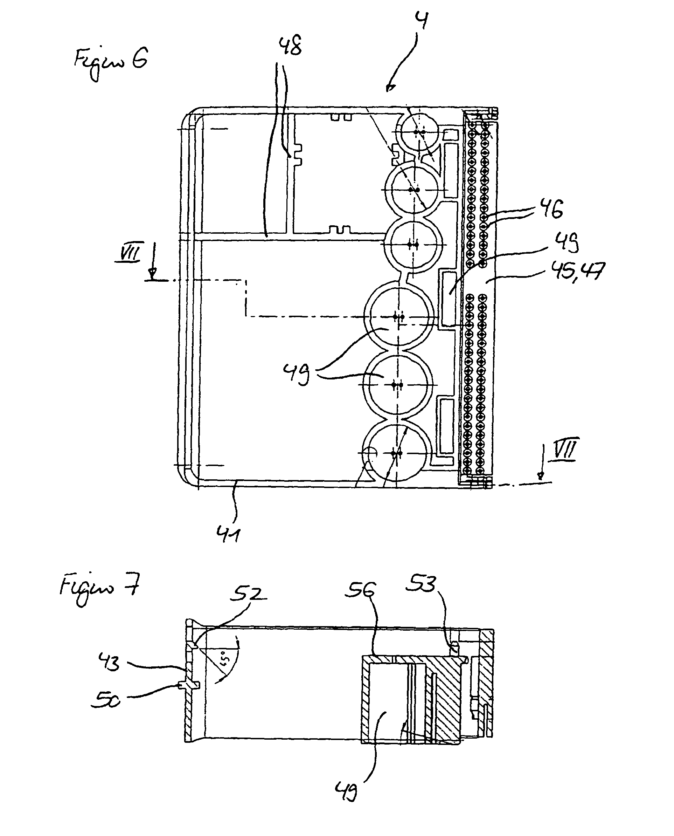

- Figuren 3 bis 5: verschiedene Ansichten und Schnittdarstellungen des Trägerkörpers gemäß Figuren 1 und 2,
- Figur 6: eine Draufsicht auf den Trägerkörper,
- Figur 7: eine Schnittdarstellung entlang der Schnittlinie VII-VII der Figur 6,
- Figur 8: eine perspektivische Darstellung des Trägerkörpers mit angebrachtem Steckbuchsenkörper und
- Figur 9: ein elektrisches Steuergerät mit einem Gehäusekörper.

Der erfindungsgemäße Trägerkörper 4 umfasst einen umlaufenden stabilen Rahmensteg 41, der einen rechteckigen oder quadratischen Grundriss aufweist und innerhalb seiner Rahmenstruktur Verbindungsstege 48 aufweisen kann. Die Verbindungsstege 48 sind vorzugsweise als Bauteilaufnahmen ausgestaltet. Weitere Bauteilaufnahmen 49 sind zur Fixierung und Stabilisierung von zylindrischen Bauteilen, beispielsweise Elektrolytkondensatoren, vorgesehen. Eine beidseitig mittig an der Rückseite 43 verlaufende Versteifung 50 dient zur Stabilisierung des Trägerkörpers 4 gegen Verwindungen.

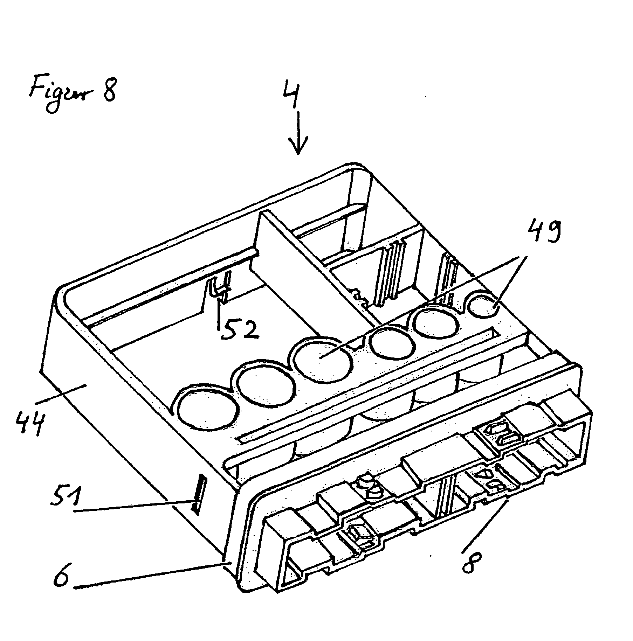

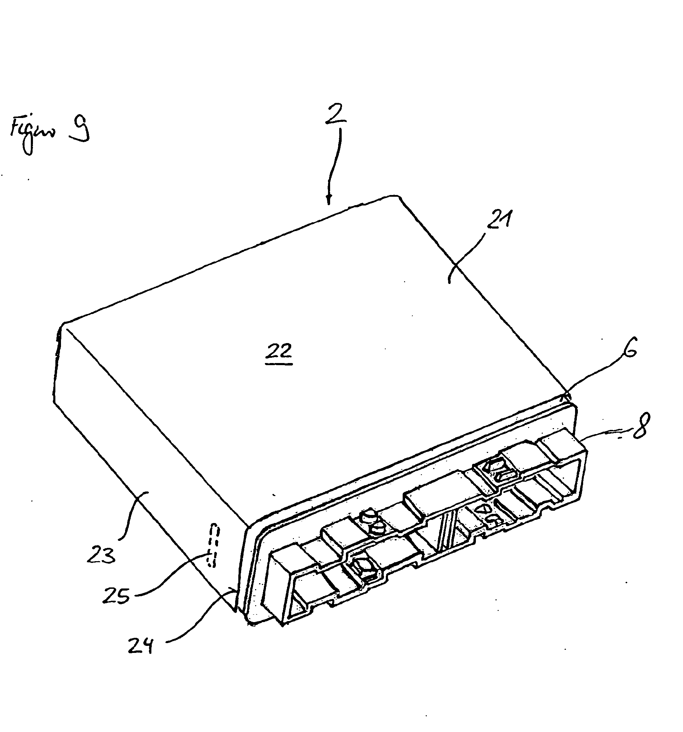

An einer Frontseite 42 ist eine waagrecht angeordnete Fädelplatte 45 vorgesehen, die eine Vielzahl von Stiftdurchführungen 46 aufweist und die gleichzeitig eine Stiftleiste 47 darstellt. Eine Schaltungsanordnung mit einer Vielzahl von zu kontaktierenden Schaltungskomponenten, die üblicherweise als Platine bezeichnet wird, kann von unten in den Trägerkörper 4 eingesetzt werden und wird in diesem Fall vom umlaufenden Rahmensteg 41 umschlossen. Zur rastenden Fixierung des Schaltungsträgers ist ein Rasthaken 52 an der Rückseite 43 des Trägerkörpers 4 vorgesehen. Zwei Rastbügel 54 an jeder Rahmenseitefläche 44 in einem Bereich vor der Frontseite 42 dienen zur rastenden Fixierung eines Steckbuchsenkörpers 8 (vgl. Figuren 8 und 9).

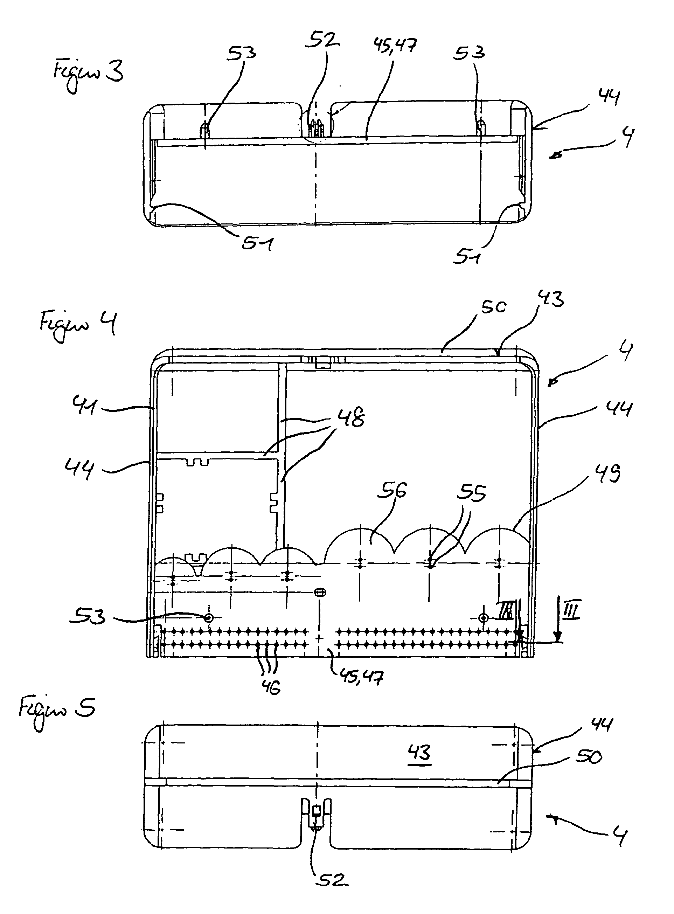

Zwei aus dem Boden 56 ragende Zentrierstifte 53 in einem Bereich nahe der Frontseite 42 (vgl. Fig. 3 und 4) dienen ebenfalls zur Lagefixierung des Steckbuchsenkörpers 8. In Fig. 4 ist insbesondere der Boden 56 der Bauteilaufnahmen 49 erkennbar, in dem für jedes zu fixierende Bauteil jeweils Durchführungen 55 angebracht sind.

Der Trägerkörper 4 kann mit einer umlaufenden Dichtung 6 an seiner Frontseite 42 versehen sein, die zusammen mit dem Steckbuchsenkörper 8 angebracht wird. Das fertig bestückte und montierte Bauteil kann zu einem Steuergerät 2 zusammengefügt werden (vgl. Fig. 9), wozu der bestückte Trägerkörper 4 bis zu einem Anschlag in einen Gehäuseeinschub 24 eines Gehäusekörpers 21 einschiebbar ist. Dabei rasten Rastnasen 51 an den Rahmenseitenflächen 44 in Rastmulden 25 an Innenseiten der Gehäuseseitenflächen 23 ein sorgen und für eine dichte Verbindung des Trägerkörpers 4 im Gehäusekörper 21, wodurch ein abgedichtetes Steuergerät 2 zur Verfügung gestellt wird. Aus diesem ist lediglich der Steckbuchsenkörper 8 herausgeführt, der zur elektrisch leitenden und mechanischen Verbindung mit einem Kabelbaum oder einer anderen Schaltungsperipherie dient.

Das erfindungsgemäße Steuergerät 2 kann beispielsweise ein Steuergerät einer Insassenschutzvorrichtung im Kraftfahrzeug sein.

### Bezugszeichenliste

2 Steuergerät
   - 21: Gehäusekörper
   - 22: Gehäuseoberseite
   - 23: Gehäuseseitenfläche
   - 24: Gehäuseeinschub
   - 25: Rastmulde
4 Trägerkörper
   - 41: Rahmensteg
   - 42: Frontseite
   - 43: Rückseite
   - 44: Rahmenseitenfläche
   - 45: Fädelplatte
   - 46: Stiftdurchführung
   - 47: Stiftleiste
   - 48: Verbindungssteg
   - 49: Bauteilaufnahme
   - 50: Versteifung
   - 51: Rastnase
   - 52: Rasthaken
   - 53: Zentrierstift
   - 54: Rastbügel
   - 55: Durchführung
   - 56: Boden
6 Dichtung
8 Steckbuchsenkörper

## Patentansprüche

1. Elektrisches Gerät, insbesondere Schalt- und/oder Steuergerät (2) für Kraftfahrzeuge, mit einem Gehäusekörper (21) und einem Trägerkörper (4) zur Aufnahme eines Schaltungsträgers, auf dem eine Schaltungsanordnung mit einer Vielzahl von zu kontaktierenden Schaltungskomponenten aufgebracht ist, wobei der Trägerkörper (4) zum Einschub in den Gehäusekörper (21) unter Bildung eines abgedichteten Außengehäuses ausgebildet ist, **dadurch**
**gekennzeichnet, dass**
an einer Frontseite (42) des Trägerkörpers eine Fädelplatte (45) sowie eine Stiftleiste (47) angeordnet sind, und die Fädelplatte (45) und die Stiftleiste (47) integrative Bestandteile des Trägerkörpers (4) sind.

2. Elektrisches Gerät nach Anspruch 1, **dadurch gekennzeichnet, dass** an der Frontseite (42) des Trägerkörpers (4) eine Dichtung vorgesehen ist zur Abdichtung des mit dem Schaltungsträger versehenen und in den Gehäusekörper (21) eingeschobenen Trägerkörpers (4).

3. Elektrisches Gerät nach Anspruch 1 oder 2, **dadurch gekennzeichnet, dass** die Frontseite (42) des Trägerkörpers (4) mit einem Steckbuchsenkörper (8) verbindbar ist, der bei in den Gehäusekörper (21) eingeschobenem Trägerkörper (4) von außen zugänglich ist.

4. Elektrisches Gerät nach einem der vorhergehenden Ansprüche, **dadurch gekennzeichnet, dass** der Schaltungsträger im Trägerkörper (4) verrastbar ist.

5. Elektrisches Gerät nach einem der vorhergehenden Ansprüche, **dadurch gekennzeichnet, dass** der Trägerkörper (4) mit dem Gehäusekörper (21) verrastbar ist.

## Claims

1. An electrical device, in particular a switching and/or control device (2) for motor vehicles, having a housing body (21) and a carrier body (4) for receiving a circuit carrier, on which there is applied a circuit arrangement with a plurality of circuit components to be contacted, the carrier body (4) being designed for insertion into the housing body (21), so forming a sealed outer housing, **characterised in that**
a threading plate (45) and a pin strip (47) are arranged on a front side (42) of the carrier body, and the threading plate (45) and the pin strip (47) are integrative components of the carrier body (4).

2. An electrical device according to claim 1, **characterised in that** a seal is provided on the front side (42) of the carrier body (4) for sealing the carrier body (4) provided with the circuit carrier and inserted into the housing body (21).

3. An electrical device according to claim 1 or claim 2, **characterised in that** the front side (42) of the carrier body (4) may be connected to a female connector body (8), which is accessible from the outside when the carrier body (4) has been inserted into the housing body (21).

4. An electrical device according to one of the preceding claims, **characterised in that** the circuit carrier may be latched in the carrier body (4).

5. An electrical device according to one of the preceding claims, **characterised in that** the carrier body (4) may be latched together with the housing body (21).

## Revendications

1. Appareil électrique, plus spécifiquement appareil de commutation et/ou de commande (2) pour des véhicules à moteur, comportant un corps de boîtier (21) et un corps de support (4) pour recevoir un support de circuit, sur lequel est agencé un dispositif de circuit comportant plusieurs composants de circuit devant être contactés, le corps du support (4) étant destiné à être inséré dans le corps du boîtier (21), avec formation d'un boîtier externe étanche, **caractérisé en ce que**
une plaque à enfiler (45) et une barrette à broches (47) sont agencées au niveau d'un côté avant (42) du corps de support, la plaque à enfiler (45) et la barrette à broches (47) constituant des composants faisant partie intégrante du corps de support (4).

2. Appareil électrique selon la revendication 1, **caractérisé en ce qu'**un joint est agencé au niveau du coté avant (42) du corps de support (4) pour établir l'étanchéité du corps de support (4) muni de support de circuit et inséré dans le corps du boîtier (21).

3. Appareil électrique selon les revendications 1 ou 2, **caractérisé en ce que** le côté avant (42) du corps de support (4) peut être raccordé à un corps de prise (8), accessible de l'extérieur lorsque le corps de support (4) est inséré dans le corps du boîtier (21).

4. Appareil électrique selon l'une des revendications précédentes, **caractérisé en ce que** le support de circuit peur être verrouillé dans le corps de support (4).

5. Appareil électrique selon l'une des revendications précédentes, **caractérisé en ce que** le corps de support (4) peut être verrouillé avec le corps du boîtier (21).
